# EUROPEAN PATENT APPLICATION

(11) **EP 4 679 975 A1**
(43) Date of publication of application: **14.01.2026**
(21) Application number: 25173507.2
(22) Date of filing: 30.04.2025
(51) Int. Cl.: H10F 10/14, H10F 10/166, H10F 19/90, H10F 71/00, H10F 77/20, H10F 77/30

(54) **BACK CONTACT SOLAR CELL AND MANUFACTURING METHOD THEREOF, AND PHOTOVOLTAIC MODULE**

(30) Priority: 10.07.2024 CN 202410918524
(71) Applicant: Longi Green Energy Technology Co., Ltd., Xi'an, Shaanxi 710100 (CN)
(72) Inventor: WANG, Genshun, Xi'an, 710100 (CN); WANG, Tingting, Xi'an, 710100 (CN); LI, Jiawei, Xi'an, 710100 (CN); QIU, Haoran, Xi'an, 710100 (CN); WU, Hua, Xi'an, 710100 (CN); FANG, Liang, Xi'an, 710100 (CN); XU, Xixiang, Xi'an, 710100 (CN)
(74) Representative: Pfenning, Meinig & Partner mbB

(57) **Abstract**

The present application discloses a back contact solar cell and a manufacturing method thereof, and a photovoltaic module, and relates to the field of photovoltaic technologies, to form a minority carrier inversion layer at an edge of a first surface through a majority carrier passivation layer and arrange the majority carrier passivation layer with a relatively great thickness in a non-electrode collecting region, so as to reduce carrier recombination at the edge of the first surface. The back contact solar cell includes a semiconductor substrate, a first doped semiconductor portion, a second doped semiconductor portion, and a majority carrier passivation layer. A first surface includes a non-electrode collecting region located at an edge and an electrode collecting region located on an inner side of the non-electrode collecting region. The electrode collecting region includes minority carrier regions and majority carrier regions distributed alternately and at intervals along a first direction. Along the first direction, an outermost minority carrier region is closer to the non-electrode collecting region than an outermost majority carrier region. The first doped semiconductor portion is arranged in the majority carrier region. The second doped semiconductor portion is arranged in the minority carrier region. The majority carrier passivation layer is arranged in the non-electrode collecting region. A thickness of the majority carrier passivation layer is greater than a thickness of the second doped semiconductor portion.

## Description

### TECHNICAL FIELD

The present application relates to the field of photovoltaic technologies, and in particular, to a back contact solar cell and a manufacturing method thereof, and a photovoltaic module.

### BACKGROUND

A solar cell is an apparatus that can convert sun's light energy into electric energy. Specifically, when the solar cell is in an operating state, sunlight irradiates onto a semiconductor p-n junction of the solar cell to form new hole-electron pairs. Under an action of a built-in electric field of the p-n junction, photogenerated holes flow to a p-type region, and photogenerated electrons flow to an n-type region, so that a current can be generated when a circuit is powered on. A solar cell in which a positive electrode and a negative electrode are arranged on a back surface of the solar cell is a back contact solar cell. Compared with a double-sided contact solar cell, a front surface of the back contact solar cell is not blocked by metal electrodes, so that a light receiving surface of the back contact solar cell has higher light utilization. Therefore, the back contact solar cell has a higher short-circuit current and higher photoelectric conversion efficiency, and therefore is one of existing technical directions for realizing efficient crystalline silicon solar cells.

However, in existing back contact solar cells, collection efficiency of minority carriers at an edge part on the back surface is relatively low, which is not conducive to improving the operating efficiency of the back contact solar cell.

### SUMMARY

An objective of the present application is to provide a back contact solar cell and a manufacturing method thereof, and a photovoltaic module, to form a minority carrier inversion layer on an inner side of a semiconductor substrate at an edge of a first surface through a majority carrier passivation layer. Under an action of an electric field of the majority carrier passivation layer, the minority carrier inversion layer repels photogenerated minority carriers, so that minority carriers generated on the inner side of the semiconductor substrate at the edge of the first surface are accelerated and transmitted to an adjacent second doped semiconductor portion, helping improve the efficiency of the second doped semiconductor portion in collecting the minority carriers generated at the edge in the first surface. In addition, by arranging the majority carrier passivation layer with a relatively great thickness in a non-electrode collecting region, carrier recombination at the edge of the first surface is further reduced, thereby improving the operating efficiency of the back contact solar cell.

To achieve the foregoing objective, according to a first aspect, the present application provides a back contact solar cell. The back contact solar cell includes: a semiconductor substrate, a first doped semiconductor portion, a second doped semiconductor portion, and a majority carrier passivation layer. The semiconductor substrate includes a first surface and a second surface opposite to the first surface. The first surface includes a non-electrode collecting region located at an edge and an electrode collecting region located on an inner side of the non-electrode collecting region. The electrode collecting region includes minority carrier regions and majority carrier regions distributed alternately and at intervals along a first direction. Along the first direction, an outermost minority carrier region is closer to the non-electrode collecting region than an outermost majority carrier region. The first doped semiconductor portion is arranged in the majority carrier region. The second doped semiconductor portion is arranged in the minority carrier region. A conductivity type of the second doped semiconductor portion is opposite to a conductivity type of the first doped semiconductor portion. The majority carrier passivation layer is arranged in the non-electrode collecting region. A thickness of the majority carrier passivation layer is greater than a thickness of the second doped semiconductor portion.

In a case that the foregoing technical solution is used, in the back contact solar cell provided in the present application, the first surface of the semiconductor substrate includes the non-electrode collecting region located at the edge and the electrode collecting region located on the inner side of the non-electrode collecting region. The non-electrode collecting region indicates that structures such as the majority carrier passivation layer arranged on the non-electrode collecting region and having a conductive characteristic are not electrically connected to an interconnection structure such as a conductive electrode, an electrode net, or a welding strip, thereby ensuring that majority carriers gathered inside the majority carrier passivation layer generate an electric field and a minority carrier inversion layer is formed on an inner side of the semiconductor substrate at the edge. The electrode collecting region indicates that structures such as the first doped semiconductor portion and the second doped semiconductor portion that are arranged on the electrode collecting region and have a conductive characteristic need to be electrically connected to an interconnection structure such as a conductive electrode, an electrode net, or a welding strip, to lead out most carriers (which may be referred to as majority carriers for short) or few carriers (which may be referred to as minority carriers for short) collected by the structures, which is conducive to forming a photocurrent. It may be understood that, the structures arranged on the non-electrode collecting region are electrically insulated from the structures arranged on the electrode collecting region, to prevent the structures arranged on the non-electrode collecting region from being electrically connected to the interconnection structure such as the conductive electrode, the electrode net, or the welding strip through the structures arranged on the electrode collecting region. In addition, the electrical connection manner does not include an electrical connection implemented through the semiconductor substrate. In the foregoing case, a region located at the edge in the first surface is the non-electrode collecting region. Through such arrangement, the majority carrier passivation layer arranged in the non-electrode collecting region may be prevented from being electrically connected to a side surface with an opposite conductivity type of the semiconductor substrate caused by existence of factors such as winding plating of the second doped semiconductor portion arranged in the minority carrier region adjacent to the non-electrode collecting region, that is, the edge may be prevented from being connected and short circuited, so that the back contact solar cell has relatively high electrical stability.

Along the first direction, the outermost minority carrier region is closer to the non-electrode collecting region than the outermost majority carrier region. In this case, any film layer adjacent to the non-electrode collecting region on the outer side along the first direction is the second doped semiconductor portion. The second doped semiconductor portion is arranged in the minority carrier region, so that the second doped semiconductor portion is an emitter of the back contact solar cell. Based on this, when any film layer adjacent to the non-electrode collecting region on the outer side along the first direction is the second doped semiconductor portion, an area occupation proportion of the emitter in a range close to the non-electrode collecting region of the first surface may be increased, so that a transmission distance from the minority carriers located at the edge of the semiconductor substrate to the emitter is decreased, which is conducive to improving the efficiency of the emitter in collecting the minority carriers at the edge of the semiconductor substrate, thereby suppressing carrier recombination at the edge of the semiconductor substrate. In addition, a conductivity type of the majority carrier passivation layer arranged in the non-electrode collecting region is opposite to a conductivity type of the second doped semiconductor portion arranged in the minority carrier region, and the majority carrier passivation layer is not electrically connected to the interconnection structure such as the conductive electrode, so that the majority carriers in the majority carrier passivation layer may be enriched on the inner side of the semiconductor substrate within a range of the non-electrode collecting region to form a minority carrier inversion layer. In this case, the minority carriers located at the edge of the semiconductor substrate are repelled by the minority carrier inversion layer, so that the minority carriers on the inner side of the semiconductor substrate at the edge of the first surface are accelerated and transmitted to the adjacent second doped semiconductor portion, and the minority carriers are more easily collected and led out in time by the second doped semiconductor portion adjacent to the non-electrode collecting region, thereby further improving the efficiency of the emitter region in collecting the minority carriers at the edge of the semiconductor substrate and improving the operating efficiency of the back contact solar cell. In addition, field passivation effects of the majority carrier passivation layer and the second doped semiconductor portion to the semiconductor substrate are directly proportional to thicknesses thereof respectively. Therefore, when the thickness of the majority carrier passivation layer arranged in the non-electrode collecting region is greater than the thickness of the second doped semiconductor portion, the majority carrier passivation layer has a higher field passivation effect to the non-electrode collecting region, thereby reducing a quantity of detects in the non-electrode collecting region at the edge of the first surface and further improving the operating efficiency of the back contact solar cell.

In a possible implementation, along the first direction, a width of the non-electrode collecting region is less than a width of the minority carrier region.

In a case that the foregoing technical case is used, as described above, the structures such as the majority carrier passivation layer arranged on the non-electrode collecting region and having a conductive characteristic are not electrically connected to the interconnection structure such as the conductive electrode, the electrode net, or the welding strip. In this case, the majority carriers collected by the structures such as the majority carrier passivation layer arranged on the non-electrode collecting region and having a conductive characteristic cannot be led out, affecting the collection efficiency of the majority carriers of the back contact solar cell. Based on this, when the width of the non-electrode collecting region is less than the width of the minority carrier region along the first direction, a proportion of the non-electrode collecting region from which the majority carriers cannot be led out in the first surface can be reduced, so that a proportion of the electrode collecting region located in the first surface together with the non-electrode collecting region is relatively large, thereby improving the collection efficiency of the minority carriers and the majority carriers of the back contact solar cell and further improving the operating efficiency of the back contact solar cell.

In a possible implementation, along the first direction, the width of the non-electrode collecting region is less than 1000 µm. In an embodiment, the width of the non-electrode collecting region ranges from 100 µm to 250 µm. For beneficial effects in this case, reference may be made to the application principle of the beneficial effects when the width of the non-electrode collecting region is less than the width of the minority carrier region along the first direction, and details are not described herein.

In a possible implementation, in the first surface, the non-electrode collecting region is further arranged on an outer side of the electrode collecting region along a second direction. The second direction is different from the first direction.

In a case that the foregoing technical solution is used, the majority carrier passivation layer can be further arranged on the outer side of the electrode collecting region along the second direction, helping improve the efficiency of the emitter region in collecting the minority carriers at the edge of the semiconductor substrate along an edge of the second direction, thereby further suppressing carrier recombination at the edge of the semiconductor substrate. In addition, the majority carrier passivation layer has a higher field passivation effect to the non-electrode collecting region, so that when the non-electrode collecting region is further arranged on the outer side of the electrode collecting region along the second direction, a passivation effect to the edge along the second direction in the first surface can be further improved, thereby reducing a quantity of defects in the non-electrode collecting region at the edge of the first surface and further improving the operating efficiency of the back contact solar cell.

In a possible implementation, the second direction is perpendicular to the first direction.

In a case that the foregoing technical solution is used, in an actual application process, the first surface of the semiconductor substrate is generally in a shape of a rectangle or a rectangle with a chamfer. Based on this, when the second direction is perpendicular to the first direction, distribution of the minority carrier region and the majority carrier region better matches the shape of the first surface of the semiconductor substrate, thereby further improving the carrier collection efficiency of the first doped semiconductor portion arranged in the minority carrier region and the second doped semiconductor portion arranged in the majority carrier region, and further reducing the difficulty in interconnecting different back contact solar cells. In addition, when the second direction is perpendicular to the first direction, the non-electrode collecting region can be exactly and totally located in various parts of the edge of the first surface, and a proportion of the non-electrode collecting region at the edge of the first surface is improved, thereby further reducing a quantity of defects in the non-electrode collecting region at the edge of the first surface and further improving the operating efficiency of the back contact solar cell.

In a possible implementation, a width of the non-electrode collecting region along the second direction is less than or equal to a width of the non-electrode collecting region along the first direction. In this case, a proportion of the non-electrode collecting region from which the majority carriers cannot be led out along the second direction is reduced while it is ensured that the non-electrode collecting region at the edge along the second direction in the first surface corresponds to a relatively low carrier recombination rate under the field passivation effect of the majority carrier passivation layer, so that a proportion of the electrode collecting region located in the first surface together with the non-electrode collecting region is relatively large, thereby improving the collection efficiency of the minority carriers and the majority carriers of the back contact solar cell and further improving the operating efficiency of the back contact solar cell. In addition, a risk that the interconnection structure such as the welding strip interconnecting different back contact solar cells is connected and short circuited through the majority carrier passivation layer since the non-electrode collecting region is further arranged on the outer side of the electrode collecting region along the second direction can be further reduced, thereby ensuring that the back contact solar cell has relatively high electrical stability.

In a possible implementation, the majority carrier passivation layer includes a third doped semiconductor portion arranged on the non-electrode collecting region, a conductivity type of the third doped semiconductor portion is the same as the conductivity type of the first doped semiconductor portion, and a material of the third doped semiconductor portion is the same as a material of the first doped semiconductor portion.

In a case that the foregoing technical solution is used, the conductivity type of the third doped semiconductor portion is the same as the conductivity type of the first doped semiconductor portion, so that majority carriers can be enriched at the majority carrier passivation layer, helping form the minority carrier inversion layer in the non-electrode collecting region, thereby ensuring that the second doped semiconductor portion adjacent to the non-electrode collecting region has relatively high minority carrier collection efficiency. In addition, when the conductivity type of the third doped semiconductor portion is the same as the conductivity type of the first doped semiconductor portion and the material of the third doped semiconductor portion is the same as the material of the first doped semiconductor portion, the third doped semiconductor portion and the first doped semiconductor portion may be formed simultaneously based on the same material and through the same operation, while ensuring that an etching amount when the first doped semiconductor portion is formed can be reduced and improving the manufacturing efficiency of the back contact solar cell, when one of the third doped semiconductor portion and the first doped semiconductor portion is formed, an etching agent can be further prevented from affecting the other, thereby ensuring that the first doped semiconductor portion has relatively high carrier collection efficiency and that the third doped semiconductor portion has a relatively high passivation effect to the non-electrode collecting region, and further improving the operating performance of the back contact solar cell.

In a possible implementation, the back contact solar cell further includes a hydrogen-containing passivation layer. The hydrogen-containing passivation layer is arranged on a side of the majority carrier passivation layer facing away from the semiconductor substrate.

In a case that the foregoing technical solution is used, due to existence of the hydrogen-containing passivation layer, the non-electrode collecting region can be further passivated to further reduce a carrier recombination rate in the non-electrode collecting region, and when a structure such as the second doped semiconductor portion or an electrode is manufactured, the existence of the hydrogen-containing passivation layer can further prevent an etching agent for performing patterning treatment from affecting the majority carrier passivation layer located below the etching agent, thereby ensuring that the majority carrier passivation layer has a relatively high passivation effect to the non-electrode collecting region and that the majority carrier passivation layer has an enriching effect for majority carriers, and further improving the operating performance of the back contact solar cell.

In a possible implementation, in the first surface, a region located between the majority carrier region and the minority carrier region along the first direction is an isolation region; the first doped semiconductor portion is further arranged on the isolation region; the second doped semiconductor portion further extends to cover a part of the first doped semiconductor portion corresponding to the isolation region; and in the isolation region, the second doped semiconductor portion and the first doped semiconductor portion are spaced apart along a thickness direction of the semiconductor substrate. In this case, the first doped semiconductor portion and the second doped semiconductor portion have relatively large area occupation proportions on the first surface, so that etching amounts when selective etching are performed on a first doped semiconductor material (for manufacturing the first doped semiconductor portion) and a second doped semiconductor material (for manufacturing the second doped semiconductor portion) that are entirely arranged may be reduced, thereby improving the manufacturing efficiency of the back contact solar cell.

In a possible implementation, in a case that the back contact solar cell further includes the hydrogen-containing passivation layer, at least a part of the hydrogen-containing passivation layer and the second doped semiconductor portion are integral continuous. In this case, while ensuring that the etching amount when selective etching is performed on the second doped semiconductor material that is entirely arranged can be further reduced and improving the manufacturing efficiency of the back contact solar cell, the etching agent can be further prevented from causing damage to a corresponding passivation structure (for example, the majority carrier passivation layer) located at the edge and a side surface of the semiconductor substrate for a purpose of removing a part of the second doped semiconductor material corresponding to the non-electrode collecting region, thereby ensuring a good passivation effect to the edge and the side surface of the semiconductor substrate.

In a possible implementation, a surface of the non-electrode collecting region is a polished surface.

In a case that the foregoing technical solution is used, in an actual manufacturing process, a deposition film thickness of the majority carrier passivation layer is inversely proportional to a specific surface area of the non-electrode collecting region in which the majority carrier passivation layer is located, and the passivation effect of the majority carrier passivation layer to the non-electrode collecting region is directly proportional to the deposition thickness of the majority carrier passivation layer. Based on this, compared with a textured surface, when the surface of the non-electrode collecting region is a polished surface, the surface of the non-electrode collecting region is relatively flat, which is conducive to increasing the deposition film thickness of the majority carrier passivation layer in the non-electrode collecting region and improving the passivation effect of the majority carrier passivation layer to the non-electrode collecting region. In addition, compared with a textured surface, the polished surface has a fewer quantity of defect recombination centers, so that the carrier recombination rate at the edge of the first surface can be further reduced.

In a possible implementation, a surface of the minority carrier region is a textured surface.

In a case that the foregoing technical solution is used, the second doped semiconductor portion is arranged in the minority carrier region. The surface of the minority carrier region is a textured surface with a relatively large specific surface area. In addition, compared with a polished surface, a deposition film thickness of the second doped semiconductor portion on the textured surface is relatively small, thereby ensuring that the thickness of the majority carrier passivation layer arranged in the non-electrode collecting region can be greater than the thickness of the second doped semiconductor portion arranged in the minority carrier region, and ensuring that the non-electrode collecting region has a relatively high passivation effect. In addition, the textured surface has a relatively large specific surface area, so that a side of the second doped semiconductor portion facing away from the semiconductor substrate that is formed on the minority carrier region also has a relatively large specific surface area, which is conducive to increasing a contact area between the second doped semiconductor portion and a corresponding conductive electrode, thereby improving the contact performance between the second doped semiconductor portion and the corresponding conductive electrode.

In a possible implementation, the majority carrier passivation layer includes a doped polysilicon layer. In this case, in an actual application process, compared with a doped amorphous silicon layer, the doped polysilicon layer has a relatively large thickness, so that when the majority carrier passivation layer includes the doped polysilicon layer, the majority carrier passivation layer has a relatively large thickness, thereby further improving the passivation effect of the majority carrier passivation layer to the non-electrode collecting region.

In a possible implementation, the second doped semiconductor portion includes at least one of a doped amorphous silicon layer, a doped microcrystalline silicon layer, or a doped nanocrystalline silicon layer. In this case, compared with a doped polysilicon layer, the doped amorphous silicon layer has a relatively small thickness, so that when the second doped semiconductor portion includes the doped amorphous silicon layer, the difficulty in manufacturing a majority carrier passivation layer whose thickness is greater than that of the second doped semiconductor portion may be reduced, helping improve a yield of the back contact solar cell.

In a possible implementation, a conductivity type of the majority carrier passivation layer is an N type, and the conductivity type of the second doped semiconductor portion is a P type.

In a possible implementation, the back contact solar cell further includes a first interface passivation layer, and the first interface passivation layer is arranged between the semiconductor substrate and the first doped semiconductor portion.

In a case that the foregoing technical solution is used, a passivation contact structure formed by the first interface passivation layer and the first doped semiconductor portion has an excellent interface passivation effect and can selectively collect carriers, so that a carrier recombination rate in the majority carrier region of the first surface is at least reduced, thereby further improving the photoelectric conversion efficiency of the back contact solar cell.

In a possible implementation, the back contact solar cell further includes a second interface passivation layer, and the second interface passivation layer is at least arranged between the semiconductor substrate and the second doped semiconductor portion.

In a case that the foregoing technical solution is used, a passivation contact structure formed by the second interface passivation layer and a part of the second doped semiconductor portion located on the second region can selectively collect carriers, thereby reducing a carrier recombination rate in the minority carrier region of the first surface.

In a possible implementation, in a case that the back contact solar cell further includes the first interface passivation layer and the second interface passivation layer, the first interface passivation layer and the first doped semiconductor portion form a first passivation contact structure, and the second interface passivation layer and the second doped semiconductor portion form a second passivation contact structure, where a passivated contact type of the first passivation contact structure is different from a passivated contact type of the second passivation contact structure; and/or the first passivation contact structure is a tunneling passivation contact structure; and/or the second passivation contact structure is a heterogeneous contact structure.

In a case that the foregoing technical solution is used, when the passivated contact type of the first passivation contact structure is different from the passivated contact type of the second passivation contact structure, the passivated contact type of the first passivation contact structure and the passivated contact type of the second passivation contact structure may be regulated respectively according to requirements in different actual application scenarios, to improve the applicability of the back contact solar cell provided in the present application in different application scenarios. For example, in an actual manufacturing process, after the first passivation contact structure is formed in the majority carrier region and the second passivation contact structure that is entirely arranged is formed, pattering treatment generally needs to be performed on a mask material that is entirely arranged by using a laser processing process, to form a mask layer for performing selective etching on the second passivation contact structure. To process each part of the mask material corresponding to the majority carrier region, heat radiated by processing laser may be conducted to the first passivation contact structure. The laser has relatively high heat, so that when the first passivation contact structure has relatively high thermal stability, influence of the heat radiated by the laser on the first passivation contact structure may be reduced, and the first passivation contact structure may even not be affected by the heat radiated by the laser, thereby improving a yield of the back contact solar cell. A part of the second passivation contact structure corresponding to the majority carrier region needs to be removed, and a requirement on precision of the laser processing process is relatively high, so that a part of the second passivation contact structure corresponding to the minority carrier region is not affected by heat or is less affected by heat. In this case, the manufacturing process has a relatively low requirement on the thermal stability of the second passivation contact structure, and the thermal stability of the second passivation contact structure may be set to be lower than the thermal stability of the first passivation contact structure.

In addition, when the first passivation contact structure is a tunneling passivation contact structure, an amorphous silicon material easily forms polycrystalline silicon or monocrystalline silicon under a high temperature, and a tunneling passivation material and the polycrystalline silicon have relatively stable chemical properties under a high temperature, so that compared with a heterogeneous contact structure, a sensitive degree of the tunneling passivation contact structure to a heat loss of high-temperature laser is relatively small, and influence on the passivation effect during the laser processing process may be reduced, thereby further enlarging a process window and reducing the process difficulty. When the majority carrier passivation layer and the first doped semiconductor portion are formed simultaneously, the majority carrier passivation layer and the first interface passivation layer may better cover the non-electrode collecting region and even the side surface of the semiconductor substrate, so that a quantity of defects at the edge of the first surface may be further reduced. In addition, the heterogeneous contact structure has a passivation effect better than that of the tunneling passivation contact structure, so that in a case that the second passivation contact structure is a heterogeneous contact structure, a carrier recombination rate at an interface between the semiconductor substrate and the second interface passivation layer may be further reduced, which is conducive to improving the photoelectric conversion efficiency of the back contact solar cell.

According to a second aspect, the present application provides a photovoltaic module. The photovoltaic module includes the back contact solar cell according to the first aspect and various implementations of the first aspect.

For beneficial effects of the second aspect and various implementations of the second aspect in the present application, reference may be made to the analysis of the beneficial effects of the first aspect and various implementations of the first aspect, and details are not described herein.

According to a third aspect, the present application provides a manufacturing method of a back contact solar cell. The manufacturing method of a back contact solar cell includes: providing a semiconductor substrate, where the semiconductor substrate includes a first surface and a second surface opposite to the first surface; the first surface includes a non-electrode collecting region located at an edge and an electrode collecting region located on an inner side of the non-electrode collecting region; the electrode collecting region includes minority carrier regions and majority carrier regions distributed alternately and at intervals along a first direction; and along the first direction, an outermost minority carrier region is closer to the non-electrode collecting region than an outermost majority carrier region; forming a first doped semiconductor portion in the majority carrier region; forming a second doped semiconductor portion in the minority carrier region, where a conductivity type of the second doped semiconductor portion is opposite to a conductivity type of the first doped semiconductor portion; and forming a majority carrier passivation layer in the non-electrode collecting region, where a thickness of the majority carrier passivation layer is greater than a thickness of the second doped semiconductor portion.

In a possible implementation, the first doped semiconductor portion and the majority carrier passivation layer are formed simultaneously.

In a possible implementation, in the first surface, a region located between the majority carrier region and the minority carrier region along the first direction is an isolation region; and after the providing a semiconductor substrate, the manufacturing method of a back contact solar cell further includes: forming a first doped semiconductor material that is entirely arranged on the first surface; selectively removing a part of the first doped semiconductor material corresponding to the minority carrier region, to form a part of the first doped semiconductor material remaining in the majority carrier region and the isolation region into the first doped semiconductor portion, and to form a part of the first doped semiconductor material remaining in the non-electrode collecting region into the majority carrier passivation layer; forming a second doped semiconductor material that is entirely arranged on the minority carrier region, the first doped semiconductor portion, and the majority carrier passivation layer; and selectively removing a part of the second doped semiconductor material corresponding to the majority carrier region, to form a part of the second doped semiconductor material remaining in the minority carrier region and the isolation region into the second doped semiconductor portion, and to form a part of the second doped semiconductor material remaining in the non-electrode collecting region into at least a part of a hydrogen-containing passivation layer.

For beneficial effects of the third aspect and various implementations of the third aspect in the present application, reference may be made to the analysis of the beneficial effects of the first aspect and various implementations of the first aspect, and details are not described herein.

### BRIEF DESCRIPTION OF THE DRAWINGS

The accompanying drawings described herein are intended to provide further understanding of the present application and constitute a part of the present application. Exemplary embodiments of the present application and the description thereof are used for explaining the present application rather than constituting an improper limitation to the present application. In the accompanying drawings:
FIG. 1 is a first schematic longitudinal cross-sectional view of a first structure of a back contact solar cell according to an embodiment of the present application;
FIG. 2 is a first schematic diagram of distribution of a non-electrode collecting region and an electrode collecting region in a first surface in a back contact solar cell according to an embodiment of the present application;
FIG. 3 is a second schematic diagram of distribution of a non-electrode collecting region and an electrode collecting region in a first surface in a back contact solar cell according to an embodiment of the present application;
FIG. 4 is a second schematic longitudinal cross-sectional view of a first structure of a back contact solar cell according to an embodiment of the present application;
FIG. 5 is a third schematic longitudinal cross-sectional view of a first structure of a back contact solar cell according to an embodiment of the present application;
FIG. 6 is a fourth schematic longitudinal cross-sectional view of a first structure of a back contact solar cell according to an embodiment of the present application;
FIG. 7 is a fifth schematic longitudinal cross-sectional view of a first structure of a back contact solar cell according to an embodiment of the present application;
FIG. 8 is a sixth schematic longitudinal cross-sectional view of a first structure of a back contact solar cell according to an embodiment of the present application;
FIG. 9 is a seventh schematic longitudinal cross-sectional view of a first structure of a back contact solar cell according to an embodiment of the present application;
FIG. 10 is an eighth schematic longitudinal cross-sectional view of a first structure of a back contact solar cell according to an embodiment of the present application;
FIG. 11 is a ninth schematic longitudinal cross-sectional view of a first structure of a back contact solar cell according to an embodiment of the present application; and
FIG. 12 is a tenth schematic longitudinal cross-sectional view of a first structure of a back contact solar cell according to an embodiment of the present application.

Description of reference numerals: 11-Semiconductor substrate, 12-Non-electrode collecting region, 13-Electrode collecting region, 14-Minority carrier region, 15-Majority carrier region, 16-Isolation region, 17-First doped semiconductor portion, 18-Second doped semiconductor portion, 19-Majority carrier passivation layer, 20-Hydrogen-containing passivation layer, 21-First interface passivation layer, 22-Second interface passivation layer, 23-Insulating layer, 24-Transparent conductive layer, 25-Insulating groove, 26-First electrode, and 27-Second electrode.

### DETAILED DESCRIPTION

Embodiments of the present application are described below with reference to the accompanying drawings. However, it should be understood that, the description is only exemplary, and is not intended to limit the scope of the present application. In addition, in the following description, description of well-known structures and technologies is omitted, to avoid unnecessarily obscuring the concept of the present application.

Schematic diagrams of various structures according to the embodiments of the present application are shown in the accompanying drawings. The accompanying drawings are not drawn to scale, some details are enlarged for clearer expression, and some details may be omitted. Shapes of various regions and layers shown in the accompanying drawings, and relative sizes and positional relationships between the various regions and layers are only exemplary, and may deviate in practice due to manufacturing tolerances or technical limitations, and a person skilled in the art may additionally design regions/layers with different shapes, sizes, and relative positions according to actual requirements.

In the context of the present application, when a layer/element is referred to as being "on" another layer/element, the layer/element may be directly on the another layer/element, or an intermediate layer/element may exist between the layer/element and the another layer/element. In addition, if one layer/element is "above" another layer/element in an orientation, when the orientation is turned, the layer/element may be "below" the another layer/element. To make the technical problems to be resolved in the present application, the technical solutions, and beneficial effects more comprehensible, the following further describes the present application in detail with reference to the accompanying drawings and the embodiments. It should be understood that, the specific embodiments described herein are only used to explain the present application but are not intended to limit the present application.

In addition, the terms "first" and "second" are used only for the purpose of description, and shall not be construed as indicating or implying relative importance or implicitly indicating a quantity of indicated technical features. Therefore, a feature defined by "first" or "second" may explicitly indicate or implicitly include one or more features. In the description of the present application, unless otherwise explicitly specified, "a plurality of" means two or more than two; and unless otherwise explicitly specified, "several" means one or more than one.

In the description of the present application, it should be noted that, unless otherwise explicitly specified or limited, the terms such as "mount", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediary, internal communication between two elements, or an interactive relationship between two elements. The specific meanings of the foregoing terms in the present application may be understood according to specific situations for a person of ordinary skill in the art.

A solar cell is an apparatus that can convert sun's light energy into electric energy. Specifically, when the solar cell is in an operating state, sunlight irradiates onto a semiconductor p-n junction of the solar cell to form new hole-electron pairs. Under an action of a built-in electric field of the p-n junction, photogenerated holes flow to a p-type region, and photogenerated electrons flow to an n-type region, so that a current can be generated when a circuit is powered on. A solar cell in which a positive electrode and a negative electrode are arranged on a back surface of the solar cell is a back contact solar cell. Compared with a double-sided contact solar cell, a front surface of the back contact solar cell is not blocked by metal electrodes, so that a light receiving surface of the back contact solar cell has higher light utilization. Therefore, the back contact solar cell has a higher short-circuit current and higher photoelectric conversion efficiency, and therefore is one of existing technical directions for realizing efficient crystalline silicon solar cells.

However, in existing back contact solar cells, collection efficiency of minority carriers at an edge part on the back surface is relatively low, which is not conducive to improving the operating efficiency of the back contact solar cell.

Specifically, the back contact solar cell generally includes a semiconductor substrate, a first doped semiconductor portion, and a second doped semiconductor portion. Along a direction parallel to the back surface of the semiconductor substrate, the first doped semiconductor portion and the second doped semiconductor portion are each formed in a partial region of the back surface of the semiconductor substrate. The first doped semiconductor portion and the second doped semiconductor portion may be spaced apart alternately, or the second doped semiconductor portion may extend to cover a part of the first doped semiconductor portion facing away from the semiconductor substrate. A conductivity type of the first doped semiconductor portion is opposite to a conductivity type of the second doped semiconductor portion, to collect and lead out electrons and holes respectively, which is conducive to forming a photocurrent. When the second doped semiconductor portion extends to cover the part of the first doped semiconductor portion facing away from the semiconductor substrate, the first doped semiconductor portion and the second doped semiconductor portion that are stacked are spaced apart, thereby suppressing current leakage.

In the foregoing case, in an actual manufacturing process, when the first doped semiconductor portion and the second doped semiconductor portion are formed on the back surface, due to factors such as different flows or flow rates of deposition gas and/or doping gas in a middle region and an edge region, forming quality and uniformity of the first doped semiconductor portion and the second doped semiconductor portion in the edge region are respectively poorer than forming quality and uniformity of the first doped semiconductor portion and the second doped semiconductor portion in the middle region. As a result, a passivation effect of a part of the back contact solar cell in the edge region is poorer than a passivation effect thereof in the middle region, and recombination rates of electrons and holes in the edge region of the back contact solar cell are relatively high. In addition, in the existing back contact solar cell, as described above, when the first doped semiconductor portion and the second doped semiconductor portion are manufactured, parts in the first doped semiconductor portion and the second doped semiconductor portion that are configured to collect and lead out carriers are spaced apart alternately on the back surface, and even in the edge region of the first surface, the first doped semiconductor portion and the second doped semiconductor portion are also electrically connected to corresponding electrodes to lead out collected carriers. However, through such arrangement, the edge is prone to current leakage, and the collection efficiency of minority carriers in the edge region is relatively low, which is not conducive to improving the operating efficiency of the back contact solar cell.

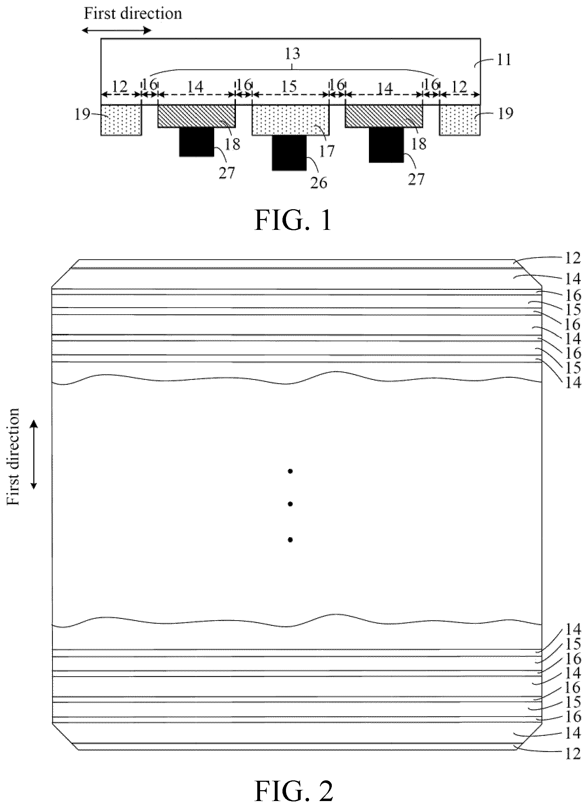

To resolve the foregoing technical problems, according to a first aspect, an embodiment of the present application provides a back contact solar cell. As shown in FIG. 1, the back contact solar cell provided in this embodiment of the present application includes: a semiconductor substrate 11, a first doped semiconductor portion 17, a second doped semiconductor portion 18, and a majority carrier passivation layer 19. The semiconductor substrate 11 includes a first surface and a second surface opposite to the first surface. The first surface includes a non-electrode collecting region 12 located at an edge and an electrode collecting region 13 located on an inner side of the non-electrode collecting region 12. The electrode collecting region 13 includes minority carrier regions 14 and majority carrier regions 15 distributed alternately and at intervals along a first direction. Along the first direction, an outermost minority carrier region 14 is closer to the non-electrode collecting region 12 than an outermost majority carrier region 15. The first doped semiconductor portion 17 is arranged in the majority carrier region 15. The second doped semiconductor portion 18 is arranged in the minority carrier region 14. A conductivity type of the second doped semiconductor portion 18 is opposite to a conductivity type of the first doped semiconductor portion 17. The majority carrier passivation layer 19 is arranged in the non-electrode collecting region 12. A thickness of the majority carrier passivation layer 19 is greater than a thickness of the second doped semiconductor portion 18.

In a case that the foregoing technical solution is used, as shown in FIG. 1, in the back contact solar cell provided in this embodiment of the present application, the first surface of the semiconductor substrate 11 includes the non-electrode collecting region 12 located at the edge and the electrode collecting region 13 located on the inner side of the non-electrode collecting region 12. The non-electrode collecting region 12 indicates that structures such as the majority carrier passivation layer 19 arranged on the non-electrode collecting region 12 and having a conductive characteristic are not electrically connected to an interconnection structure such as a conductive electrode, an electrode net, or a welding strip, thereby ensuring that majority carriers gathered inside the majority carrier passivation layer 19 generate an electric field and a minority carrier inversion layer is formed on an inner side of the semiconductor substrate 11 at the edge. The electrode collecting region 13 indicates that structures such as the first doped semiconductor portion 17 and the second doped semiconductor portion 18 that are arranged on the electrode collecting region 13 and have a conductive characteristic need to be electrically connected to an interconnection structure such as a conductive electrode, an electrode net, or a welding strip, to lead out most carriers (which may be referred to as majority carriers for short) or few carriers (which may be referred to as minority carriers for short) collected by the structures, which is conducive to forming a photocurrent. It may be understood that, the structures arranged on the non-electrode collecting region 12 are electrically insulated from the structures arranged on the electrode collecting region 13, to prevent the structures arranged on the non-electrode collecting region 12 from being electrically connected to the interconnection structure such as the conductive electrode (for example, a first electrode 26 and a second electrode 27 in the figure), the electrode net, or the welding strip through the structures arranged on the electrode collecting region 13. In addition, the electrical connection manner does not include an electrical connection implemented through the semiconductor substrate 11. In the foregoing case, a region located at the edge in the first surface is the non-electrode collecting region 12. Through such arrangement, the majority carrier passivation layer 19 arranged in the non-electrode collecting region 12 may be prevented from being electrically connected to a side surface with an opposite conductivity type of the semiconductor substrate 11 caused by existence of factors such as winding plating of the second doped semiconductor portion 18 arranged in the minority carrier region 14 adjacent to the non-electrode collecting region 12, that is, the edge may be prevented from being connected and short circuited, so that the back contact solar cell has relatively high electrical stability. Along the first direction, the outermost minority carrier region 14 is closer to the non-electrode collecting region 12 than the outermost majority carrier region 15. In this case, any film layer adjacent to the non-electrode collecting region 12 on the outer side along the first direction is the second doped semiconductor portion 18. The second doped semiconductor portion 18 is arranged in the minority carrier region 14, so that the second doped semiconductor portion 18 is an emitter of the back contact solar cell. Based on this, when any film layer adjacent to the non-electrode collecting region 12 on the outer side along the first direction is the second doped semiconductor portion 18, an area occupation proportion of the emitter in a range close to the non-electrode collecting region 12 of the first surface may be increased, so that a transmission distance from the minority carriers located at the edge of the semiconductor substrate 11 to the emitter is decreased, which is conducive to improving the efficiency of the emitter in collecting the minority carriers at the edge of the semiconductor substrate 11, thereby suppressing carrier recombination at the edge of the semiconductor substrate 11. In addition, a conductivity type of the majority carrier passivation layer 19 arranged in the non-electrode collecting region 12 is opposite to a conductivity type of the second doped semiconductor portion 18 arranged in the minority carrier region 14, and the majority carrier passivation layer 19 is not electrically connected to the interconnection structure such as the conductive electrode, so that the majority carriers in the majority carrier passivation layer 19 may be enriched on the inner side of the semiconductor substrate 11 within a range of the non-electrode collecting region 12 to form a minority carrier inversion layer. In this case, the minority carriers located at the edge of the semiconductor substrate 11 are repelled by the minority carrier inversion layer, so that the minority carriers on the inner side of the semiconductor substrate 11 at the edge of the first surface are accelerated and transmitted to the adjacent second doped semiconductor portion, and the minority carriers are more easily collected and led out in time by the second doped semiconductor portion 18 adjacent to the non-electrode collecting region 12, thereby further improving the efficiency of the emitter in collecting the minority carriers at the edge of the semiconductor substrate 11 and improving the operating efficiency of the back contact solar cell. In addition, field passivation effects of the majority carrier passivation layer 19 and the second doped semiconductor portion 18 to the semiconductor substrate 11 are directly proportional to thicknesses thereof respectively. Therefore, when the thickness of the majority carrier passivation layer 19 arranged in the non-electrode collecting region 12 is greater than the thickness of the second doped semiconductor portion 18, the majority carrier passivation layer 19 has a higher field passivation effect to the non-electrode collecting region 12, thereby reducing a quantity of detects in the non-electrode collecting region 12 at the edge of the first surface and further improving the operating efficiency of the back contact solar cell.

In an actual application process, a material and a conductivity type of the semiconductor substrate are not specifically limited in the embodiments of the present application. For example, the semiconductor substrate may be a silicon substrate. Alternatively, the semiconductor substrate may be any substrate made of a semiconductor material, for example, a germanium silicon substrate, a germanium substrate, or a gallium arsenide substrate. In addition, the semiconductor substrate may be an N-type semiconductor substrate or may be a P-type semiconductor substrate.

The semiconductor substrate includes the first surface and the second surface opposite to the first surface, the first surface of the semiconductor substrate corresponds to a back surface of the back contact solar cell, and the second surface of the semiconductor substrate corresponds to a light receiving surface of the back contact solar cell. The first surface includes a non-electrode collecting region located at an edge and an electrode collecting region located on an inner side of the non-electrode collecting region. Specifically, distribution of the non-electrode collecting region in the first surface may be determined according to distribution of the majority carrier passivation layer that is formed on the first surface and not electrically connected to the interconnection structure such as the conductive electrode. For distribution of the electrode collecting region in the first surface, after the distribution of the non-electrode collecting region in the first surface is determined, a region located on the inner side of the non-electrode collecting region in the first surface is the electrode collecting region. As shown in FIG. 2, in the first surface, the non-electrode collecting region 12 may be arranged only on an outer side of the electrode collecting region 13 along the first direction. In this case, the electrode collecting region 13 may be continuously distributed from one side edge to another side edge of the first surface along an extending direction of the non-electrode collecting region 12, and there is no need to perform selective etching on the first doped semiconductor portion and the second doped semiconductor portion located at two side edges along the extending direction of the non-electrode collecting region 12 in the first surface during manufacturing, so that a proportion of the electrode collecting region 13 in the first surface may be further increased while an etching amount is reduced and the manufacturing efficiency of the back contact solar cell is improved, thereby further improving the carrier collection efficiency of the first doped semiconductor portion and the second doped semiconductor portion. The first direction may be any direction parallel to the first surface. In an embodiment, in a case that the first surface of the semiconductor substrate is in a shape of a rectangle or a rectangle with a chamfer, the first direction may be an extending direction of any side parallel to a non-chamfer side of the rectangle.

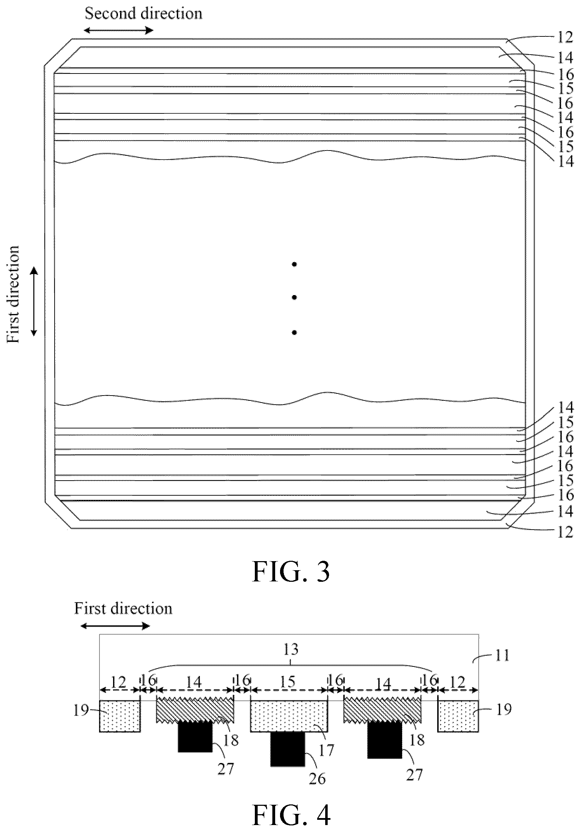

Alternatively, as shown in FIG. 3, in the first surface, the non-electrode collecting region 12 is further arranged on an outer side of the electrode collecting region 13 along a second direction. The second direction is different from the first direction. In this case, the majority carrier passivation layer can be further arranged on the outer side of the electrode collecting region 13 along the second direction, helping improve the efficiency of the emitter region in collecting the minority carriers at the edge of the semiconductor substrate along an edge of the second direction, thereby further suppressing carrier recombination at the edge of the semiconductor substrate. In addition, the majority carrier passivation layer has a higher field passivation effect to the non-electrode collecting region 12, so that when the non-electrode collecting region 12 is further arranged on the outer side of the electrode collecting region 13 along the second direction, a passivation effect to the edge along the second direction in the first surface can be further improved, thereby reducing a quantity of defects in the non-electrode collecting region 12 at the edge of the first surface and further improving the operating efficiency of the back contact solar cell. The second direction may be any direction parallel to the first surface and different from the first direction.

In an embodiment, the second direction may be perpendicular to the first direction. In this case, in an actual application process, the first surface of the semiconductor substrate is generally in a shape of a rectangle or a rectangle with a chamfer. Based on this, when the second direction is perpendicular to the first direction, distribution of the minority carrier region and the majority carrier region better matches the shape of the first surface of the semiconductor substrate, thereby further improving the carrier collection efficiency of the first doped semiconductor portion arranged in the minority carrier region and the second doped semiconductor portion arranged in the majority carrier region respectively, and further reducing the difficulty in interconnecting different back contact solar cells. In addition, when the second direction is perpendicular to the first direction, the non-electrode collecting region can be exactly and totally located in various parts of the edge of the first surface, and a proportion of the non-electrode collecting region at the edge of the first surface is improved, thereby further reducing a quantity of defects in the non-electrode collecting region at the edge of the first surface and further improving the operating efficiency of the back contact solar cell.

For a width of the non-electrode collecting region along the first direction and a width of the non-electrode collecting region along the second direction when the non-electrode collecting region is further arranged on the outer side of the electrode collecting region along the second direction, as described above, the structures such as the majority carrier passivation layer arranged on the non-electrode collecting region and having a conductive characteristic are not electrically connected to the interconnection structure such as the conductive electrode, the electrode net, or the welding strip. In this case, the majority carriers collected by the structures such as the majority carrier passivation layer arranged on the non-electrode collecting region and having a conductive characteristic cannot be led out, affecting the collection efficiency of the majority carriers of the back contact solar cell. However, the majority carrier passivation layer arranged in the non-electrode collecting region can help improve the efficiency of the second doped semiconductor portion in the non-electrode collecting region in collecting the minority carriers, and have a relatively high passivation effect to the edge of the first surface. Based on this, the width of the non-electrode collecting region along the first direction and the width of the non-electrode collecting region along the second direction may be determined according to a requirement on the passivation effect to the edge of the first surface and a requirement on the carrier collection efficiency of the edge of the first surface of the back contact solar cell in an actual application scenario, which are not specifically limited herein.

For example, along the first direction, the width of the non-electrode collecting region may be less than or equal to a width of the minority carrier region. When the width of the non-electrode collecting region is less than the width of the minority carrier region along the first direction, a proportion of the non-electrode collecting region from which the majority carriers cannot be led out in the first surface can be reduced, so that a proportion of the electrode collecting region located in the first surface together with the non-electrode collecting region is relatively large, thereby improving the collection efficiency of the minority carriers and the majority carriers of the back contact solar cell and further improving the operating efficiency of the back contact solar cell. A specific width of the non-electrode collecting region along the first direction may be determined according to a specification of the back contact solar cell.

For example, along the first direction, the width of the non-electrode collecting region may be less than 1000 µm. For example, the width of the non-electrode collecting region may be 100 µm, 150 µm, 200 µm, 250 µm, 300 µm, 350 µm, 400 µm, 600 µm, 800 µm, or 1000 µm, for the application principle of beneficial effects in this case, reference may be made to the application principle of the beneficial effects when the width of the non-electrode collecting region is less than the width of the minority carrier region along the first direction, and details are not described herein.

For example, the width of the non-electrode collecting region along the second direction may be less than or equal to the width of the non-electrode collecting region along the first direction. In this case, a proportion of the non-electrode collecting region from which the majority carriers cannot be led out along the second direction is reduced while it is ensured that the non-electrode collecting region at the edge along the second direction in the first surface corresponds to a relatively low carrier recombination rate under the field passivation effect of the majority carrier passivation layer, so that a proportion of the electrode collecting region located in the first surface together with the non-electrode collecting region is relatively large, thereby improving the collection efficiency of the minority carriers and the majority carriers of the back contact solar cell and further improving the operating efficiency of the back contact solar cell. In addition, a risk that the interconnection structure such as the welding strip interconnecting different back contact solar cells is connected and short circuited through the majority carrier passivation layer since the non-electrode collecting region is further arranged on the outer side of the electrode collecting region along the second direction can be further reduced, thereby ensuring that the back contact solar cell has relatively high electrical stability.

For the electrode collecting region included by the first surface, the electrode collecting region includes minority carrier regions and majority carrier regions distributed alternately and at intervals along the first direction. In the first surface, a region located between the majority carrier region and the minority carrier region along the first direction is defined as an isolation region. Distribution of the minority carrier region, the majority carrier region, and the isolation region in the first surface may be determined according to distribution of the first doped semiconductor portion and the second doped semiconductor portion that are formed on the first surface. Specifically, the first doped semiconductor portion included by the back contact solar cell and configured to collect and lead out the majority carriers is at least arranged in the majority carrier region, so that a distribution range of the majority carrier region in the first surface may be determined according to a distribution requirement on at least a part of the first doped semiconductor portion in an actual application scenario. The second doped semiconductor portion included by the back contact solar cell and configured to collect and lead out the minority carriers is at least arranged in the minority carrier region, so that a distribution range of the minority carrier region in the first surface may be determined according to a distribution requirement on at least a part of the second doped semiconductor portion in an actual application scenario. After the ranges of the minority carrier region and the majority carrier region are determined, a distribution range of the isolation region located between the minority carrier region and the majority carrier region in the electrode collecting region in the first surface is also determined.

It may be understood that, the minority carrier region corresponds to the emitter of the back contact solar cell, and the majority carrier region corresponds to a back-surface field region of the back contact solar cell; and one of the minority carrier region and the majority carrier region corresponds to a P-type region, and the other corresponds to an N-type region. The isolation region may correspond to a PN overlapping region, or may correspond to a PN isolation region.

Region shapes of the minority carrier region and the majority carrier region may be set according to an actual requirement, which are not specifically limited herein. For example, the minority carrier region and the majority carrier region may be strip-shaped and spaced apart alternately, or may be interdigitated and spaced apart alternately.

In terms of surface morphologies, the second surface of the semiconductor substrate may be a polished surface or a textured surface. In an embodiment, the second surface is a textured surface to improve a light trapping effect of the second surface, thereby improving the light utilization of the semiconductor substrate.

As shown in FIG. 4, a surface of the non-electrode collecting region 12 included by the first surface may be a polished surface. In this case, in an actual manufacturing process, a deposition film thickness of the majority carrier passivation layer 19 is inversely proportional to a specific surface area of the non-electrode collecting region 12 in which the majority carrier passivation layer is located, and the passivation effect of the majority carrier passivation layer 19 to the non-electrode collecting region 12 is directly proportional to the deposition thickness of the majority carrier passivation layer. Based on this, compared with a textured surface, when the surface of the non-electrode collecting region 12 is a polished surface, the surface of the non-electrode collecting region 12 is relatively flat, which is conducive to increasing the deposition film thickness of the majority carrier passivation layer 19 in the non-electrode collecting region 12 and improving the passivation effect of the majority carrier passivation layer 19 to the non-electrode collecting region 12. In addition, compared with a textured surface, the polished surface has a fewer quantity of defect recombination centers, so that the carrier recombination rate at the edge of the first surface can be further reduced.

For example, as shown in FIG. 4, a surface of the minority carrier region 14 may be a textured surface. In this case, the second doped semiconductor portion 18 is arranged in the minority carrier region 14. The surface of the minority carrier region 14 is a textured surface with a relatively large specific surface area. In addition, compared with a polished surface, a deposition film thickness of the second doped semiconductor portion 18 on the textured surface is relatively small, thereby ensuring that the thickness of the majority carrier passivation layer 19 arranged in the non-electrode collecting region 12 can be greater than the thickness of the second doped semiconductor portion 18 arranged in the minority carrier region 14, and ensuring that the non-electrode collecting region 12 has a relatively high passivation effect. In addition, the textured surface has a relatively large specific surface area, so that a side of the second doped semiconductor portion 18 facing away from the semiconductor substrate 11 that is formed on the minority carrier region 14 also has a relatively large specific surface area, which is conducive to increasing a contact area between the second doped semiconductor portion 18 and a corresponding conductive electrode, thereby improving the contact performance between the second doped semiconductor portion and the corresponding conductive electrode.

Certainly, the non-electrode collecting region and the minority carrier region may alternatively have the same surface morphology, and sizes of texture structures arranged on the surfaces of the non-electrode collecting region and the minority carrier region are different, so that surface roughness of the non-electrode collecting region is less than surface roughness of the minority carrier region. For example, both the non-electrode collecting region and the minority carrier region may be polished surfaces or textured surfaces. When the surfaces of both the non-electrode collecting region and the minority carrier region are textured surfaces, the size of the textured surface on the non-electrode collecting region is less than the size of the textured surface on the minority carrier region. Alternatively, the non-electrode collecting region and the minority carrier region may alternatively have different surface morphologies other than the polished surface or the textured surface. Alternatively, the non-electrode collecting region and the minority carrier region may have the same surface morphology and the sizes of the texture structures are also the same. In this case, a majority carrier passivation layer with a larger thickness and a second doped semiconductor portion with a smaller thickness may be obtained by separately adjusting deposition parameters.

For the first doped semiconductor portion and the second doped semiconductor portion, in terms of conductivity types, the conductivity type of the first doped semiconductor portion and the conductivity type of the second doped semiconductor portion are not specifically limited in the embodiments of the present application, provided that the first doped semiconductor portion corresponds to the minority carrier region and the second doped semiconductor portion corresponds to the majority carrier region. Specifically, the conductivity type of the first doped semiconductor portion may be an N type, and the conductivity type of the second doped semiconductor portion in this case is a P type. Alternatively, the conductivity type of the first doped semiconductor portion may be a P type, and the conductivity type of the second doped semiconductor portion in this case is an N type.

In terms of formation positions, as shown in FIG. 1 and FIG. 4, the first doped semiconductor portion 17 may be arranged in only the majority carrier region 15, and the second doped semiconductor portion 18 may be arranged in only the minority carrier region 14. In this case, the first doped semiconductor portion 17 and the second doped semiconductor portion 18 may be isolated through the isolation region 16, thereby suppressing current leakage. In this case, the isolation region 16 may also be arranged between the non-electrode collecting region 12 and the electrode collecting region 13, to isolate a conductive structure such as the majority carrier passivation layer 19 arranged in the non-electrode collecting region 12 from the first doped semiconductor portion 17 and the second doped semiconductor portion 18 arranged in the electrode collecting region 13, thereby preventing short circuit.

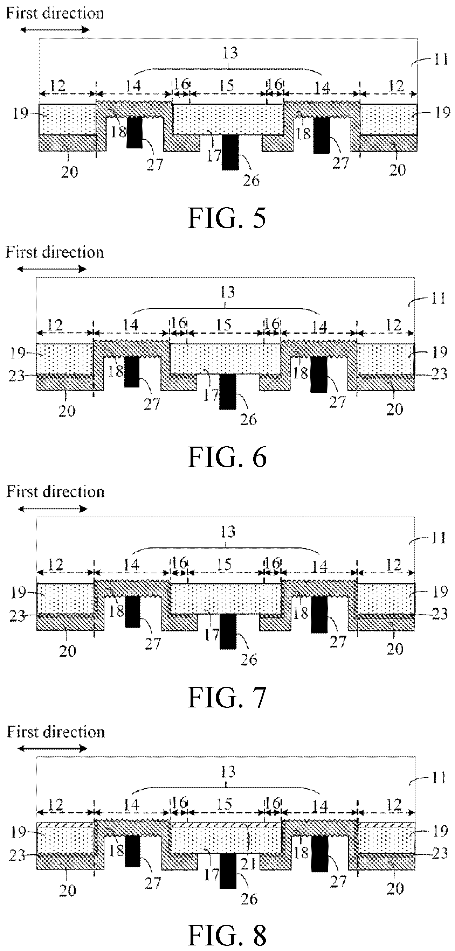

Alternatively, as shown in FIG. 5, the first doped semiconductor portion 17 is not only arranged in the majority carrier region 15 but also arranged in the isolation region 16. In addition, the second doped semiconductor portion 18 is not only arranged in the minority carrier region 14 but also extends to cover a part of the first doped semiconductor portion 17 corresponding to the isolation region 16. In the isolation region 16, the second doped semiconductor portion 18 and the first doped semiconductor portion 17 are spaced apart along a thickness direction of the semiconductor substrate 11, to suppress current leakage, thereby further improving the operating performance of the back contact solar cell. In this case, the first doped semiconductor portion 17 and the second doped semiconductor portion 18 have relatively large area occupation proportions on the first surface, so that etching amounts when selective etching are performed on a first doped semiconductor material (for manufacturing the first doped semiconductor portion 17) and a second doped semiconductor material (for manufacturing the second doped semiconductor portion 18) that are entirely arranged may be reduced, thereby improving the manufacturing efficiency of the back contact solar cell.

The back contact solar cell may include an isolation layer. Based on this, in the isolation region, the second doped semiconductor portion and the first doped semiconductor portion may be isolated from each other through the isolation layer along the thickness direction of the semiconductor substrate. Specifically, as shown in FIG. 6, the isolation layer (for example, an insulating layer 23 in the figure) may be arranged only between the first doped semiconductor portion 17 and the second doped semiconductor portion 18, corresponding to the isolation region 16, along the thickness direction of the semiconductor substrate 11. Alternatively, as shown in FIG. 7, the isolation layer may be arranged between the first doped semiconductor portion 17 and the second doped semiconductor portion 18, corresponding to the isolation region 16, along the thickness direction of the semiconductor substrate 11 and a direction parallel to the first surface. The isolation layer may include only a part of a second interface passivation layer 22 extending to a space between the first doped semiconductor portion 17 and the second doped semiconductor portion 18 in the following. Alternatively, the isolation layer may include only the insulating layer 23, and the insulating layer 23 may be a mask layer formed before selective etching is performed on the first doped semiconductor material (for manufacturing the first doped semiconductor portion 17) that is entirely arranged in an actual manufacturing process and used for etching protection, or the insulating layer 23 may be an insulating layer 23 separately formed on the part of the first doped semiconductor portion 17 corresponding to the isolation region 16 after the first doped semiconductor portion 17 is formed in an actual manufacturing process. Alternatively, the isolation layer may include the part of the second interface passivation layer 22 extending to the space between the first doped semiconductor portion 17 and the second doped semiconductor portion 18 and the insulating layer 23.

In addition, materials of the first doped semiconductor portion and/or the second doped semiconductor portion may include any semiconductor material such as silicon, silicon germanium, germanium, or gallium arsenide. In terms of arrangement of substances, a crystalline phase of each of the first doped semiconductor portion and/or the second doped semiconductor portion may be an amorphous semiconductor portion, a microcrystalline semiconductor portion, a nanocrystalline semiconductor portion, a monocrystalline semiconductor portion, or a polycrystalline semiconductor portion. The materials of the first doped semiconductor portion and the second doped semiconductor portion may be the same or may be different. For example, the materials of the first doped semiconductor portion and the second doped semiconductor portion both may be doped polysilicon. For another example, the materials of the first doped semiconductor portion and the second doped semiconductor portion both may include at least one of doped amorphous silicon, doped microcrystalline silicon, or doped nanocrystalline silicon. For another example, the material of the first doped semiconductor portion may be doped polysilicon, and the material of the second doped semiconductor portion may include at least one of doped amorphous silicon, doped microcrystalline silicon, or doped nanocrystalline silicon.

In an embodiment, the first doped semiconductor portion may include a doped polysilicon layer. In this case, in an actual application process, compared with a doped amorphous silicon layer, the doped polysilicon layer has a relatively large thickness, and the majority carrier passivation layer may be integrally formed with the first doped semiconductor portion having the same conductivity type, so that when the first doped semiconductor portion includes the doped polysilicon layer and the first doped semiconductor portion and the majority carrier passivation layer are integrally formed, the majority carrier passivation layer has a relatively large thickness, thereby further improving the passivation effect of the majority carrier passivation layer to the non-electrode collecting region. Certainly, the first doped semiconductor portion may alternatively include another semiconductor material, and the first doped semiconductor portion may alternatively not be integrally formed with the majority carrier passivation layer.

In an embodiment, the second doped semiconductor portion includes at least one of a doped amorphous silicon layer, a doped microcrystalline silicon layer, or a doped nanocrystalline silicon layer. In this case, compared with a doped polysilicon layer, the doped amorphous silicon layer has a relatively small thickness, so that when the second doped semiconductor portion includes the doped amorphous silicon layer, the difficulty in manufacturing a majority carrier passivation layer whose thickness is greater than that of the second doped semiconductor portion may be reduced, helping improve a yield of the back contact solar cell.

As shown in FIG. 6 and FIG. 7, the first doped semiconductor portion 17 may be directly at least arranged in the majority carrier region 15. Alternatively, as shown in FIG. 8, the back contact solar cell may further include a first interface passivation layer 21. The first interface passivation layer 21 is arranged between the semiconductor substrate 11 and the first doped semiconductor portion 17. In this case, a passivation contact structure formed by the first interface passivation layer 21 and the first doped semiconductor portion 17 has an excellent interface passivation effect and can selectively collect carriers, so that a carrier recombination rate in the minority carrier region 14 of the first surface of the semiconductor substrate 11 is reduced, thereby further improving the photoelectric conversion efficiency of the back contact solar cell. A material and a thickness of the first interface passivation layer 21 may be set according to the material of the first doped semiconductor portion 17 and an actual requirement, which are not specifically limited herein. For example, when the material of the first doped semiconductor portion is doped polysilicon, the first interface passivation layer is a tunneling passivation layer. For another example, when the material of the first doped semiconductor portion includes at least one of doped amorphous silicon, doped microcrystalline silicon, or doped nanocrystalline silicon, the first interface passivation layer is an intrinsic amorphous silicon layer, an intrinsic microcrystalline silicon layer, an intrinsic nanocrystalline silicon layer, or a mixing layer thereof.

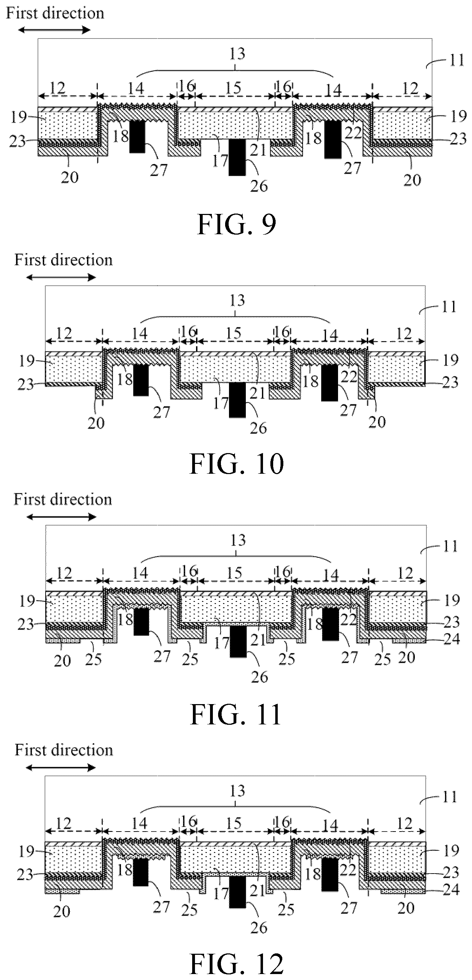

For the second doped semiconductor portion, as shown in FIG. 7, the second doped semiconductor portion 18 may be directly at least arranged in the minority carrier region 14. Alternatively, as shown in FIG. 9, the back contact solar cell may further include a second interface passivation layer 22, and the second interface passivation layer 22 is at least arranged between the semiconductor substrate 11 and the second doped semiconductor portion 18. Specifically, when the second doped semiconductor portion 18 is arranged only in the minority carrier region 14, the second interface passivation layer 22 is arranged only between the semiconductor substrate 11 and the second doped semiconductor portion 18. When the second doped semiconductor portion 18 further extends to cover the part of the first doped semiconductor portion 17 corresponding to the isolation region 16, the second interface passivation layer 22 further extends to the space between the second doped semiconductor portion 18 and the first doped semiconductor portion 17. In this case, a passivation contact structure formed by the second interface passivation layer 22 and a part of the second doped semiconductor portion 18 located on the second region can selectively collect carriers, thereby reducing a carrier recombination rate in the minority carrier region 14 of the first surface. A material and a thickness of the second interface passivation layer 22 may be set according to the material of the second doped semiconductor portion 18 and an actual requirement, which are not specifically limited herein. For example, when the material of the second doped semiconductor portion is doped polysilicon, the second interface passivation layer is a tunneling passivation layer. For another example, when the material of the second doped semiconductor portion includes at least one of doped amorphous silicon, doped microcrystalline silicon, or doped nanocrystalline silicon, the second interface passivation layer is an intrinsic amorphous silicon layer, an intrinsic microcrystalline silicon layer, an intrinsic nanocrystalline silicon layer, or a mixing layer thereof.

In addition, in a case that the back contact solar cell includes the first interface passivation layer and the second interface passivation layer, the first interface passivation layer and the first doped semiconductor portion form a first passivation contact structure, and the second interface passivation layer and the second doped semiconductor portion form a second passivation contact structure.

A passivated contact type of the first passivation contact structure may be the same as a passivated contact type of the second passivation contact structure. For example, each of the first passivation contact structure and the second passivation contact structure is a tunneling passivation contact structure or a heterogeneous contact structure. Alternatively, a passivated contact type of the first passivation contact structure is different from a passivated contact type of the second passivation contact structure. For example, one of the first passivation contact structure and the second passivation contact structure is a tunneling passivation contact structure, and the other is a heterogeneous contact structure. **In** this case, when the passivated contact type of the first passivation contact structure is different from the passivated contact type of the second passivation contact structure, the passivated contact type of the first passivation contact structure and the passivated contact type of the second passivation contact structure may be regulated respectively according to requirements in different actual application scenarios, to improve the applicability of the back contact solar cell provided in the embodiments of the present application in different application scenarios.

For example, in an actual manufacturing process, after the first passivation contact structure is formed in the majority carrier region and the second passivation contact structure that is entirely arranged is formed, pattering treatment generally needs to be performed on a mask material that is entirely arranged by using a laser processing process, to form a mask layer for performing selective etching on the second passivation contact structure. To process each part of the mask material corresponding to the majority carrier region, heat radiated by processing laser may be conducted to the first passivation contact structure. The laser has relatively high heat, so that when the first passivation contact structure has relatively high thermal stability, influence of the heat radiated by the laser on the first passivation contact structure may be reduced, and the first passivation contact structure may even not be affected by the heat radiated by the laser, thereby improving a yield of the back contact solar cell. A part of the second passivation contact structure corresponding to the majority carrier region needs to be removed, and a requirement on precision of the laser processing process is relatively high, so that a part of the second passivation contact structure corresponding to the minority carrier region is not affected by heat or is less affected by heat. In this case, the manufacturing process has a relatively low requirement on the thermal stability of the second passivation contact structure, and the thermal stability of the second passivation contact structure may be set to be lower than the thermal stability of the first passivation contact structure.

For another example, in an actual manufacturing process, a tunneling passivation layer included by a tunneling passivation contact structure may be formed by using a thermal oxidation process. In this case, compared with a passivation layer that is made of an intrinsic semiconductor material such as intrinsic amorphous silicon and formed by using a low-temperature process, the tunneling passivation layer has better coverage performance. Based on this, the first passivation contact structure may be set as a tunneling passivation contact structure, and after the first passivation contact structure is formed, the side surface of the semiconductor substrate may also be covered by at least a part of the first passivation contact structure, thereby reducing a quantity of defects on the side surface of the semiconductor substrate and further improving the operating performance of the back contact solar cell. When the majority carrier passivation layer and the first doped semiconductor portion are formed simultaneously, the majority carrier passivation layer and the first interface passivation layer may better cover the non-electrode collecting region and even the side surface of the semiconductor substrate, so that a quantity of defects at the edge of the first surface may be further reduced. In addition, when the first passivation contact structure is a tunneling passivation contact structure, an amorphous silicon material easily forms polycrystalline silicon or monocrystalline silicon under a high temperature, and a tunneling passivation material and the polycrystalline silicon have relatively stable chemical properties under a high temperature, so that compared with a heterogeneous contact structure, a sensitive degree of the tunneling passivation contact structure to a heat loss of high-temperature laser is relatively small, and influence on the passivation effect during the laser processing process may be reduced, thereby further enlarging a process window and reducing the process difficulty. In addition, the heterogeneous contact structure has a passivation effect better than that of the tunneling passivation contact structure, so that in a case that the second passivation contact structure is a heterogeneous contact structure, a carrier recombination rate at an interface between the semiconductor substrate and the second interface passivation layer may be further reduced, which is conducive to improving the photoelectric conversion efficiency of the back contact solar cell.

For the majority carrier passivation layer, in terms of film layer structures, the majority carrier passivation layer may include a third doped semiconductor portion arranged on the non-electrode collecting region, and a conductivity type of the third doped semiconductor portion is the same as the conductivity type of the first doped semiconductor portion. In this case, the conductivity type of the third doped semiconductor portion is the same as the conductivity type of the first doped semiconductor portion, so that majority carriers can be enriched at the majority carrier passivation layer, helping form the minority carrier inversion layer in the non-electrode collecting region, thereby ensuring that the second doped semiconductor portion adjacent to the non-electrode collecting region has relatively high minority carrier collection efficiency.

In terms of film layer structures, the majority carrier passivation layer may be a single-layer structure. In this case, the third doped semiconductor portion may only include a single-layer doped semiconductor layer arranged on the non-electrode collecting region. Alternatively, the majority carrier passivation layer may be a laminated structure. In this case, the third doped semiconductor portion may include a plurality of doped semiconductor layers stacked on the non-electrode collecting region along the thickness direction of the semiconductor substrate. In this case, doping concentrations of dopants in different doped semiconductor layers may be the same or may be different.

In terms of materials, a material of the majority carrier passivation layer is not specifically limited in the embodiments of the present application, and may be determined according to an actual requirement and an actual manufacturing process, provided that the thickness of the majority carrier passivation layer is greater than the thickness of the second doped semiconductor portion.

Specifically, when the majority carrier passivation layer includes the third doped semiconductor portion, a material of the third doped semiconductor portion may be the same as the material of the first doped semiconductor portion. In this case, when the conductivity type of the third doped semiconductor portion is the same as the conductivity type of the first doped semiconductor portion and the material of the third doped semiconductor portion is also the same as the material of the first doped semiconductor portion, the third doped semiconductor portion and the first doped semiconductor portion may be formed simultaneously based on the same material and through the same operation in this case, while an etching amount when the first doped semiconductor portion can be reduced and the manufacturing efficiency of the back contact solar cell can be improved, when one of the third doped semiconductor portion and the first doped semiconductor portion is formed, an etching agent can be further prevented from affecting the other, thereby ensuring that the first doped semiconductor portion has relatively high carrier collection efficiency and that the third doped semiconductor portion has a relatively high passivation effect to the non-electrode collecting region, and further improving the operating performance of the back contact solar cell.

Certainly, the material of the third doped semiconductor portion included by the majority carrier passivation layer may alternatively be different from the material of the first doped semiconductor portion. In this case, the third doped semiconductor portion and the first doped semiconductor portion may be formed in different operations and based on different materials, to improve the applicability of the back contact solar cell provided in the embodiments of the present application in different application scenarios.

In an actual manufacturing process, the majority carrier passivation layer may be integrally formed with the first doped semiconductor portion, that is, the majority carrier passivation layer and the first doped semiconductor portion are formed simultaneously based on the same material and through the same operation. In this case, when the back contact solar cell further includes the first interface passivation layer, the first interface passivation layer may be further arranged between a part of the semiconductor substrate corresponding to the non-electrode collecting region and the majority carrier passivation layer, to further passivate the non-electrode collecting region, thereby reducing a quantity of defects in the non-electrode collecting region. In addition, the majority carrier passivation layer may alternatively not be integrally formed with the first doped semiconductor portion. In this case, a majority carrier passivation layer with a corresponding material and a corresponding thickness may be separately arranged according to an actual requirement.

For example, the majority carrier passivation layer may include a doped polysilicon layer. In this case, in an actual application process, compared with a doped amorphous silicon layer, the doped polysilicon layer has a relatively large thickness, so that when the majority carrier passivation layer includes the doped polysilicon layer, the majority carrier passivation layer has a relatively large thickness, thereby further improving the passivation effect of the majority carrier passivation layer to the non-electrode collecting region.

A specific conductivity type of the majority carrier passivation layer may be determined according to a conductivity type of the semiconductor substrate and the material of the majority carrier passivation layer, provided that the majority carrier passivation layer can form a minority carrier inversion layer.

For example, the conductivity type of the majority carrier passivation layer may be an N type, and the conductivity type of the second doped semiconductor portion may be a P type. **In** this case, as described above, in an embodiment, the majority carrier passivation layer includes a doped polysilicon layer, and the second doped semiconductor portion includes a doped amorphous silicon layer. In addition, compared with a P-type doped polysilicon layer, the contact performance between a P-type doped amorphous silicon layer and a conductive material is better, which is conducive to reducing a transmission loss between the P-type doped semiconductor portion and the conductive material in the back contact solar cell, thereby further improving the operating performance of the back contact solar cell.

In a possible implementation, as shown in FIG. 9, the back contact solar cell may further include a hydrogen-containing passivation layer 20. The hydrogen-containing passivation layer 20 is arranged on a side of the majority carrier passivation layer 19 facing away from the semiconductor substrate 11. In this case, due to existence of the hydrogen-containing passivation layer 20, the non-electrode collecting region 12 can be further passivated to further reduce a carrier recombination rate in the non-electrode collecting region 12, and when a structure such as the second doped semiconductor portion 18 or an electrode is manufactured, the existence of the hydrogen-containing passivation layer 20 can further prevent an etching agent for performing patterning treatment from affecting the majority carrier passivation layer 19 located below the etching agent, thereby ensuring that the majority carrier passivation layer 19 has a relatively high passivation effect to the non-electrode collecting region 12 and that the majority carrier passivation layer 19 has an enriching effect for majority carriers, and further improving the operating performance of the back contact solar cell.

A material of the hydrogen-containing passivation layer is not specifically limited in the embodiments of the present application, provided that the non-electrode collecting region can be further passivated through hydrogen ions. For example, the hydrogen-containing passivation layer may include at least one of a silicon nitride layer, a hydrogen-containing intrinsic amorphous silicon layer, a hydrogen-containing silicon oxide layer, or a hydrogen-containing aluminum oxide layer. For another example, the hydrogen-containing passivation layer may include a doped semiconductor layer whose conductivity type is opposite to that of the majority carrier passivation layer.

Specifically, in a case that the hydrogen-containing passivation layer includes the doped semiconductor layer whose conductivity type is opposite to that of the majority carrier passivation layer, when the first doped semiconductor portion is further arranged in the isolation region and the second doped semiconductor portion further extends to covers the part of the first doped semiconductor portion corresponding to the isolation region, at least a part of the hydrogen-containing passivation layer and the second doped semiconductor portion may be integral continuous. In this case, while the etching amount when selective etching is performed on the second doped semiconductor material that is entirely arranged can be further reduced and the manufacturing efficiency of the back contact solar cell can be further improved, the etching agent can be further prevented from causing damage to a corresponding passivation structure (for example, the majority carrier passivation layer) located at the edge and a side surface of the semiconductor substrate for a purpose of removing a part of the second doped semiconductor material corresponding to the non-electrode collecting region, thereby ensuring a good passivation effect to the edge and the side surface of the semiconductor substrate.

Certainly, in a case that the hydrogen-containing passivation layer includes the doped semiconductor layer whose conductivity type is opposite to that of the majority carrier passivation layer, the hydrogen-containing passivation layer and the second doped semiconductor portion may be separately manufactured.

In addition, as shown in FIG. 9, in a case that the hydrogen-containing passivation layer 20 includes the doped semiconductor layer whose conductivity type is opposite to that of the majority carrier passivation layer 19, when at least a part of the hydrogen-containing passivation layer 20 and the second doped semiconductor portion 18 are integral continuous and the back contact solar cell further includes the second interface passivation layer 22, the hydrogen-containing passivation layer 20 may also include a part of the second interface passivation layer 22 corresponding to the non-electrode collecting region 12.

As shown in FIG. 9 and FIG. 10, the hydrogen-containing passivation layer 20 may be arranged only on a partial region of the majority carrier passivation layer 19 facing away from the semiconductor substrate 11, or may be arranged on an entire region of the majority carrier passivation layer 19 facing away from the semiconductor substrate 11. A formation range of the hydrogen-containing passivation layer 20 on the majority carrier passivation layer 19 may be set according to an actual requirement, which is not specifically limited herein.

In a possible implementation, as shown in FIG. 11 and FIG. 12, in a case that the first doped semiconductor portion 17 is further arranged in the isolation region 16 and the second doped semiconductor portion 18 further extends to cover the part of the first doped semiconductor portion 17 corresponding to the isolation region 16, the back contact solar cell may further include a transparent conductive layer 24. The transparent conductive layer 24 covers the first doped semiconductor portion 17, the second doped semiconductor portion 18, and the majority carrier passivation layer 19. In addition, an insulating groove 25 is provided in the transparent conductive layer 24, and the insulating groove 25 is configured to electrically insulate the majority carrier passivation layer 19 from the second doped semiconductor portion 18 in the minority carrier region 14 and the first doped semiconductor portion 17 in the majority carrier region 15 respectively and electrically insulate the second doped semiconductor portion 18 in the minority carrier region 14 from the first doped semiconductor portion 17 in the majority carrier region 15.

A specific arrangement position of the insulating groove may be set according to an actual requirement, provided that the specific arrangement position can be applied to the back contact solar cell provided in the embodiments of the present application.

According to a second aspect, an embodiment of the present application provides a photovoltaic module. The photovoltaic module includes the back contact solar cell according to the first aspect and various implementations of the first aspect.

For beneficial effects of the second aspect and various implementations of the second aspect in this embodiment of the present application, reference may be made to the analysis of the beneficial effects of the first aspect and various implementations of the first aspect, and details are not described herein.

According to a third aspect, an embodiment of the present application provides a manufacturing method of a back contact solar cell. Specifically, the method for manufacturing a back contact solar cell includes the following steps:
providing a semiconductor substrate, where the semiconductor substrate includes a first surface and a second surface opposite to the first surface; the first surface includes a non-electrode collecting region located at an edge and an electrode collecting region located on an inner side of the non-electrode collecting region; the electrode collecting region includes minority carrier regions and majority carrier regions distributed alternately and at intervals along a first direction; and along the first direction, an outermost minority carrier region is closer to the non-electrode collecting region than an outermost majority carrier region; forming a first doped semiconductor portion in the majority carrier region; forming a second doped semiconductor portion in the minority carrier region, where a conductivity type of the second doped semiconductor portion is opposite to a conductivity type of the first doped semiconductor portion; and forming a majority carrier passivation layer in the non-electrode collecting region, where a thickness of the majority carrier passivation layer is greater than a thickness of the second doped semiconductor portion.

Specifically, for a material and a conductivity type of the semiconductor substrate and specific distribution of a non-electrode collecting region and an electrode collecting region in the first surface, reference may be made to the foregoing description, and details are not described herein. In addition, a formation sequence of the first doped semiconductor portion and the second doped semiconductor portion is not specifically limited in the embodiments of the present application. "A conductivity type of the second doped semiconductor portion is opposite to a conductivity type of the first doped semiconductor portion" in the step "forming a second doped semiconductor portion in the minority carrier region" is only a limitation to the conductivity type of the first doped semiconductor portion and the conductivity type of the second doped semiconductor portion, and does not specifically limit the formation sequence of the first doped semiconductor portion and the second doped semiconductor portion. In an actual manufacturing process, the first doped semiconductor portion arranged in the majority carrier region may be first formed, and the second doped semiconductor portion arranged in the minority carrier region is then formed; or the second doped semiconductor portion arranged in the minority carrier region may be first formed, and the first doped semiconductor portion arranged in the majority carrier region is then formed.

The following describes a process of forming the first doped semiconductor portion and the second doped semiconductor portion by using an example in which the first doped semiconductor portion is first formed and the second doped semiconductor portion is then formed:
A first case: When the first doped semiconductor portion is arranged only in the majority carrier region and the second doped semiconductor portion is arranged only in the minority carrier region, a first intrinsic semiconductor layer that is entirely arranged may be formed by using a process such as chemical vapor deposition. Next, doping treatment may be performed on the first intrinsic semiconductor layer by using a process such as diffusion or ion implantation, to form the first intrinsic semiconductor layer into the first doped semiconductor portion. Next, a mask layer arranged on a side of the first doped semiconductor portion facing away from the semiconductor substrate is formed. When a material of the first doped semiconductor portion includes silicon and the first doped semiconductor portion may be formed by using a diffusion process, while the first doped semiconductor portion is formed, a doped silicate glass layer is also formed on the side of the first doped semiconductor portion facing away from the semiconductor substrate. Based on this, when the mask layer is the doped silicate glass layer, there is no need to additionally form the mask layer. When the mask layer does not include the doped silicate glass layer, the mask layer needs to be additionally formed on the side of the first doped semiconductor portion facing away from the semiconductor substrate by using a deposition process, and a material of the mask layer in this case may be silicon nitride or silicon oxynitride. Parts of the mask layer corresponding to the isolation region and the minority carrier region may be then at least removed by using an etching process such as laser etching. When the majority carrier passivation layer is not integrally formed with the first doped semiconductor portion, a part of the mask layer corresponding to the non-electrode collecting region further needs to be removed. When the majority carrier passivation layer is integrally formed with the first doped semiconductor portion, only the parts of the mask layer corresponding to the isolation region and the minority carrier region need to be removed. Next, under a protection effect of the mask layer, a part of the first doped semiconductor portion that is not covered by the mask layer may be removed by using an etching process such as wet etching. Next, a second intrinsic semiconductor layer that is entirely arranged may be formed on the first doped semiconductor portion, the isolation region, the minority carrier region, and the non-electrode collecting region by using a deposition process. Then, doping treatment may be performed on the second intrinsic semiconductor layer by using a process such as diffusion or ion implantation, to form the second intrinsic semiconductor layer into the second doped semiconductor portion. Then, a mask layer may be formed on the second doped semiconductor portion by using the method described above, and the mask layer covers a part of the second doped semiconductor portion corresponding to the minority carrier region. Then, under a protection effect of the mask layer, a part of the second doped semiconductor portion that is not covered by the mask layer is removed.

A second case: When the first doped semiconductor portion is further arranged in the isolation region and the second doped semiconductor portion further extends to cover a part of the first doped semiconductor portion corresponding to the isolation region, a first intrinsic semiconductor layer that is entirely arranged may be formed by using a process such as chemical vapor deposition. Next, doping treatment may be performed on the first intrinsic semiconductor layer by using a process such as diffusion or ion implantation, to form the first intrinsic semiconductor layer into the first doped semiconductor portion. Next, a mask layer arranged on a side of the first doped semiconductor portion facing away from the semiconductor substrate is formed. For a formation process of the mask layer, reference may be made to the foregoing description, and details are not described herein. A part of the mask layer corresponding to the minority carrier region may be at least removed by using an etching process such as laser etching. When the majority carrier passivation layer is not integrally formed with the first doped semiconductor portion, a part of the mask layer corresponding to the non-electrode collecting region further needs to be removed. When the majority carrier passivation layer is integrally formed with the first doped semiconductor portion, only the part of the mask layer corresponding to the minority carrier region needs to be removed. Next, under a protection effect of the mask layer, a part of the first doped semiconductor portion that is not covered by the mask layer may be removed by using an etching process such as wet etching. Next, a second intrinsic semiconductor layer that is entirely arranged may be formed on the first doped semiconductor portion, the minority carrier region, and the non-electrode collecting region by using a deposition process. Then, doping treatment may be performed on the second intrinsic semiconductor layer by using a process such as diffusion or ion implantation, to form the second intrinsic semiconductor layer into the second doped semiconductor portion. Then, a mask layer may be formed on the second doped semiconductor portion by using the method described above, and the mask layer at least covers parts of the second doped semiconductor portion corresponding to the isolation region and the minority carrier region. When the back contact solar cell further includes a hydrogen-containing passivation layer that is integrally formed with the second doped semiconductor portion, the mask layer further needs to cover a part of the second doped semiconductor portion corresponding to the non-electrode collecting region. When the back contact solar cell does not include the hydrogen-containing passivation layer or the hydrogen-containing passivation layer is not integrally formed with the second doped semiconductor portion, the mask layer only needs to cover the parts of the second doped semiconductor portion corresponding to the isolation region and the minority carrier region. Then, under a protection effect of the mask layer, a part of the second doped semiconductor portion that is not covered by the mask layer is removed.

It can be learned from the foregoing content that the first doped semiconductor portion may be simultaneously formed with the majority carrier passivation layer, so that damage of an etching agent to the non-electrode collecting region can further be reduced while the manufacturing efficiency of the back contact solar cell is improved, thereby reducing a quantity of defects in the non-electrode collecting region.

Certainly, the majority carrier passivation layer may alternatively not be simultaneously formed with the first doped semiconductor portion. In this case, a formation sequence of the majority carrier passivation layer is not specifically limited in the embodiments of the present application. The majority carrier passivation layer may be formed after the first doped semiconductor portion and the second doped semiconductor portion are formed, or may be formed before the first doped semiconductor portion and the second doped semiconductor portion are formed, or may be formed after one of the first doped semiconductor portion and the second doped semiconductor portion is manufactured and before the other is manufactured. Specifically, a majority passivation material that is entirely arranged may be formed, and selective etching is then performed on the majority passivation material under a protection effect of the mask layer, to only retain a part of the majority passivation material corresponding to the non-electrode collecting region.

For example, after the providing a semiconductor substrate, the manufacturing method of a back contact solar cell further includes the following steps: forming a first doped semiconductor material that is entirely arranged on the first surface; selectively removing a part of the first doped semiconductor material corresponding to the minority carrier region, to form a part of the first doped semiconductor material remaining in the majority carrier region and the isolation region into the first doped semiconductor portion, and to form a part of the first doped semiconductor material remaining in the non-electrode collecting region into the majority carrier passivation layer; forming a second doped semiconductor material that is entirely arranged on the minority carrier region, the first doped semiconductor portion, and the majority carrier passivation layer; and selectively removing a part of the second doped semiconductor material corresponding to the majority carrier region, to form a part of the second doped semiconductor material remaining in the minority carrier region and the isolation region into the second doped semiconductor portion, and to form a part of the second doped semiconductor material remaining in the non-electrode collecting region into at least a part of a hydrogen-containing passivation layer. **In** this case, the majority carrier passivation layer and the first doped semiconductor portion are integrally formed based on the first doped semiconductor material. The at least a part of the hydrogen-containing passivation layer and the second doped semiconductor portion are integrally formed based on the second doped semiconductor material, so that damage of the etching agent to the non-electrode collecting region can further be reduced while the manufacturing efficiency is improved, thereby reducing a quantity of defects in the non-electrode collecting region. **In** addition, for a specific manufacturing process in this case, reference may be made to a corresponding manufacturing process in the second case described above, and details are not described herein.

For beneficial effects of the third aspect and various implementations of the third aspect in this embodiment of the present application, reference may be made to the analysis of the beneficial effects of the first aspect and various implementations of the first aspect, and details are not described herein.

**In** the foregoing description, technical details such as patterning and etching of the layers are not described in detail. However, a person skilled in the art should understand that a layer, a region, and the like in a required shape may be formed through various technical means. **In** addition, to form the same structure, a person skilled in the art may further design a method that is not exactly the same as the method described above. **In** addition, although the embodiments are separately described above, this does not mean that the measures in the embodiments cannot be advantageously used in combination.

The embodiments of the present application are described above. However, the embodiments are only provided for clearer description, and are not intended to limit a scope of the present application. The scope of the present application is defined by the appended claims and equivalents thereof. A person skilled in the art may make various substitutes and modifications without departing from the scope of the present application, and the substitutes and modifications shall fall within the scope of the present application.

## Claims

1. A back contact solar cell, comprising:
a semiconductor substrate, wherein the semiconductor substrate comprises a first surface and a second surface opposite to the first surface; the first surface comprises a non-electrode collecting region located at an edge and an electrode collecting region located on an inner side of the non-electrode collecting region; the electrode collecting region comprises minority carrier regions and majority carrier regions distributed alternately and at intervals along a first direction; and along the first direction, an outermost minority carrier region is closer to the non-electrode collecting region than an outermost majority carrier region;
a first doped semiconductor portion, arranged in the majority carrier region;
a second doped semiconductor portion, arranged in the minority carrier region, wherein a conductivity type of the second doped semiconductor portion is opposite to a conductivity type of the first doped semiconductor portion; and
a majority carrier passivation layer, arranged in the non-electrode collecting region, wherein a thickness of the majority carrier passivation layer is greater than a thickness of the second doped semiconductor portion.

2. The back contact solar cell according to claim 1, wherein along the first direction, a width of the non-electrode collecting region is less than a width of the minority carrier region; and/or
along the first direction, the width of the non-electrode collecting region is less than 1000 [tM.

3. The back contact solar cell according to any of claims 1 or 2, wherein in the first surface, the non-electrode collecting region is further arranged on an outer side of the electrode collecting region along a second direction; and the second direction is different from the first direction.

4. The back contact solar cell according to claim 3, wherein the second direction is perpendicular to the first direction; and/or
a width of the non-electrode collecting region along the second direction is less than or equal to a width of the non-electrode collecting region along the first direction.

5. The back contact solar cell according to any of claims 1 to 4, wherein the majority carrier passivation layer comprises a third doped semiconductor portion arranged on the non-electrode collecting region, a conductivity type of the third doped semiconductor portion is the same as the conductivity type of the first doped semiconductor portion, and a material of the third doped semiconductor portion is the same as a material of the first doped semiconductor portion.

6. The back contact solar cell according to any of claims 1 to 5, wherein the back contact solar cell further comprises a hydrogen-containing passivation layer; and the hydrogen-containing passivation layer is arranged on a side of the majority carrier passivation layer facing away from the semiconductor substrate.

7. The back contact solar cell according to any one of claims 1 to 6, wherein in the first surface, a region located between the majority carrier region and the minority carrier region along the first direction is an isolation region;
the first doped semiconductor portion is further arranged on the isolation region;
the second doped semiconductor portion further extends to cover a part of the first doped semiconductor portion corresponding to the isolation region; and in the isolation region, the second doped semiconductor portion and the first doped semiconductor portion are spaced apart along a thickness direction of the semiconductor substrate.

8. The back contact solar cell according to any of claims 6 or 7, wherein in a case that the back contact solar cell further comprises the hydrogen-containing passivation layer, at least a part of the hydrogen-containing passivation layer and the second doped semiconductor portion are integral continuous.

9. The back contact solar cell according to any one of claims 1 to 8, wherein a surface of the non-electrode collecting region is a polished surface; and/or
a surface of the minority carrier region is a textured surface.

10. The back contact solar cell according to any one of claims 1 to 9, wherein the majority carrier passivation layer comprises a doped polysilicon layer; and/or
the second doped semiconductor portion comprises at least one of a doped amorphous silicon layer, a doped microcrystalline silicon layer, or a doped nanocrystalline silicon layer; and/or
a conductivity type of the majority carrier passivation layer is an N type, and the conductivity type of the second doped semiconductor portion is a P type.

11. The back contact solar cell according to any one of claims 1 to 10, wherein the back contact solar cell further comprises a first interface passivation layer, and the first interface passivation layer is arranged between the semiconductor substrate and the first doped semiconductor portion; and/or
the back contact solar cell further comprises a second interface passivation layer, and the second interface passivation layer is at least arranged between the semiconductor substrate and the second doped semiconductor portion, wherein in a case that the back contact solar cell further comprises the first interface passivation layer and the second interface passivation layer, the first interface passivation layer and the first doped semiconductor portion preferably form a first passivation contact structure, and the second interface passivation layer and the second doped semiconductor portion form a second passivation contact structure, wherein
a passivated contact type of the first passivation contact structure is different from a passivated contact type of the second passivation contact structure; and/or the first passivation contact structure is a tunneling passivation contact structure; and/or the second passivation contact structure is a heterogeneous contact structure.

12. A photovoltaic module, comprising the back contact solar cell according to any one of claims 1 to 11.

13. A manufacturing method of a back contact solar cell, comprising:
providing a semiconductor substrate, wherein the semiconductor substrate comprises a first surface and a second surface opposite to the first surface; the first surface comprises a non-electrode collecting region located at an edge and an electrode collecting region located on an inner side of the non-electrode collecting region; the electrode collecting region comprises minority carrier regions and majority carrier regions distributed alternately and at intervals along a first direction; and along the first direction, an outermost minority carrier region is closer to the non-electrode collecting region than an outermost majority carrier region;
forming a first doped semiconductor portion in the majority carrier region;
forming a second doped semiconductor portion in the minority carrier region, wherein a conductivity type of the second doped semiconductor portion is opposite to a conductivity type of the first doped semiconductor portion; and
forming a majority carrier passivation layer in the non-electrode collecting region, wherein a thickness of the majority carrier passivation layer is greater than a thickness of the second doped semiconductor portion.

14. The manufacturing method of a back contact solar cell according to claim 13, wherein the first doped semiconductor portion and the majority carrier passivation layer are formed simultaneously.

15. The manufacturing method of a back contact solar cell according to claim 13, wherein in the first surface, a region located between the majority carrier region and the minority carrier region along the first direction is an isolation region; after the providing a semiconductor substrate, the manufacturing method of a back contact solar cell further comprises:
forming a first doped semiconductor material that is entirely arranged on the first surface;
selectively removing a part of the first doped semiconductor material corresponding to the minority carrier region, to form a part of the first doped semiconductor material remaining in the majority carrier region and the isolation region into the first doped semiconductor portion, and to form a part of the first doped semiconductor material remaining in the non-electrode collecting region into the majority carrier passivation layer;
forming a second doped semiconductor material that is entirely arranged on the minority carrier region, the first doped semiconductor portion, and the majority carrier passivation layer; and
selectively removing a part of the second doped semiconductor material corresponding to the majority carrier region, to form a part of the second doped semiconductor material remaining in the minority carrier region and the isolation region into the second doped semiconductor portion, and to form a part of the second doped semiconductor material remaining in the non-electrode collecting region into at least a part of a hydrogen-containing passivation layer.
